# EUROPEAN PATENT APPLICATION

(11) **EP 1 833 100 A2**
(43) Date of publication of application: **12.09.2007**
(21) Application number: 07250866.6
(22) Date of filing: 01.03.2007
(51) Int. Cl.: H01L 31/18, H01L 31/0392, H01L 27/146

(54) **Light-detecting device and manufacturing method thereof**

(30) Priority: 06.03.2006 JP 2006059621
(71) Applicant: MATSUSHITA ELECTRIC INDUSTRIAL CO., LTD., Osaka 571-8501 (JP)
(72) Inventor: Hirai, Jun, c/o Matsushita Electric Industrial Co. Ltd., Chuo-ku Osaka 540-6319 (JP); Suzuki, Masakatsu, c/o Matsushita Electric Industrial Co. Ltd., Chuo-ku Osaka 540-6319 (JP); Murakami, Ichiro, c/o Matsushita Electric Industrial Co. Ltd., Chuo-ku Osaka 540-6319 (JP); Hirofuji, Yuichi, c/o Matsushita Electric Industrial Co. Ltd., Chuo-ku Osaka 540-6319 (JP)
(74) Representative: Crawford, Andrew Birkby

(57) **Abstract**

A light-detecting device, comprising: a semiconductor substrate 101 that is composed of silicon as a base material, and contains carbon at a predetermined concentration; and an epitaxial layer 102 that is formed on the semiconductor substrate 101 and composed of silicon as a base material, the epitaxial layer 102 including a light-detecting unit (mainly 104) a predetermined distance away from the semiconductor substrate 101, wherein the semiconductor substrate 101 is formed using a crystal growth method from melt obtained by melting a material containing silicon and a material containing carbon so that carbon is contained in the semiconductor substrate 101 at the predetermined concentration.

## Description

### BACKGROUND OF THE INVENTION

### (1) Field of the Invention

The present invention relates to a light-detecting device and a manufacturing method thereof, and especially to a gettering technology.

### (2) Description of the Related Art

A gettering technology is generally applied to a solid-state image pickup device which is one type of light-detecting device, to reduce a white scratch and a dark current. The gettering technology is a technology for removing a heavy-metal impurity (Fe, Ni, and the like) and a crystal defect as main factors of a white scratch and the like from a device forming area of a semiconductor substrate. In IG (Intrinsic Gettering) as a typical gettering technology, a BMD ((Bulk Micro Defect) mainly an oxygen precipitation defect) is generated inside of a semiconductor substrate by performing a heat treatment. This causes a distortion stress for getting a heavy-metal impurity and a crystal defect. As a result, a heavy-metal impurity is removed from a device forming area of a semiconductor substrate.

In recent years, a technology for improving a gettering effect is developed. For example, Japanese Published Patent Application No. H06-338507 (Japanese Patent No. 3384506) discloses an ion implantation technology for implanting carbon into a silicon substrate. By ion- implanting carbon into a silicon substrate, a distortion stress increases because generation of a BMD is promoted. In addition, a distortion stress is caused because an atomic radius of each of silicon and carbon is different. As a result, a gettering effect is more improved.

However, research and development by the inventors of the present invention has revealed that a gettering effect is improved by ion-implanting carbon into a silicon substrate, but variations of a blooming suppression voltage, saturation volume of a light-detecting unit, a read voltage and the like (hereinafter, referred to as "an electric characteristic variation") become larger among manufactured solid-state image pickup devices. If an electric characteristic variation becomes larger among devices, a low-power solid- state image pickup device cannot be realized because various kinds of applied voltages are required to be higher.

Note that this problem occurs not only in a solid-state image pickup device but also in a light-detecting device to which a gettering technology is applied (such as light-receiving elements for photocoupler, optical communication, an optical pickup and the like).

### SUMMARY OF THE INVENTION

An object of the present invention is therefore to provide a light-detecting device for improving a gettering effect and reducing an electric characteristic variation, and a manufacturing method of the light-detecting device.

The above object is fulfilled by a light-detecting device, comprising: a semiconductor substrate that is composed of a first element as a base material, and contains a second element at a predetermined concentration, the second element being a homologous element of the first element; and an epitaxial layer that is formed on the semiconductor substrate and composed of the first element as a base material, the epitaxial layer including a light-detecting unit a predetermined distance away from the semiconductor substrate, wherein the semiconductor substrate is formed using a crystal growth method from melt obtained by melting a material containing the first element and a material containing the second element so that the second element is contained in the semiconductor substrate at the predetermined concentration.

The inventors confirm from an experiment that, with the above-stated construction, a gettering effect can be improved and an electric characteristic variation of a light-detecting device can be reduced.

The inventors suppose that an electric characteristic variation canbe reduced by the following reasons. (1) An electric characteristic variation is caused by a distribution variation of a second element (such as carbon) in a semiconductor substrate. (2) By adding the second element to melt obtained by melting materials of the semiconductor substrate, the distribution variation of the second element in the semiconductor substrate can be more reduced compared to an ion implantation method for implanting the second element.

The reason (1) is presumed as follows.

A BMD tends to be generated near a second element. Therefore, distribution of a BMD varies depending on distribution of the second element. A distribution variation of a BMD causes variations of parasitic capacity, parasitic resistance, and the like in a semiconductor substrate. As a result, an electric characteristic in a semiconductor substrate varies.

The reason (2) is presumed as follows.

By adding a second element to melt obtained by melting materials of a semiconductor substrate, the second element is substantially uniformly distributed in the semiconductor substrate in a crystal growth process. On the other hand, if a second element is added by an ion implantation method, it is difficult that the second element is substantially uniformly distributed in a semiconductor substrate. This is mainly because an ion beam has a gradient of an ion density in a radial direction, and there may be an accuracy error when an ion beam is scanned in a whole area of a semiconductor substrate (wafer) . Considering this, a distribution variation of a second element in a semiconductor substrate can be more reduced by adding a second element to melt obtained by melting materials of a semiconductor substrate compared to an ion implantation method for implanting a second element.

Also, the first element is silicon, the second element is carbon, and the predetermined concentration is in a range of 1×10¹⁶ atoms/cm³ to 2.5×10¹⁷ atoms/cm³ inclusive.

With the above-stated construction, since a carbon concentration in a silicon substrate is equal to or larger than 1×10¹⁶ atoms/cm³, a BMD as a gettering site can be formed in a very dense state. As a result, a gettering effect can be improved. Also, since the carbon concentration in the silicon substrate is equal to or less than 2.5×10¹⁷ atoms/cm³, a BMD cannot be excessively formed. Therefore, strength degradation of a semiconductor substrate caused by a dislocation and a slip can be prevented.

Moreover, a number of BMDs included in the semiconductor substrate perunit area of a cross section is in a range of 5×10⁵/cm² to 5×10⁷/cm² inclusive.

With the above-stated construction, since the number of BMDs of a semiconductor substrate per unit area of a cross section is equal to or larger than 5×10⁵/cm², a heavy-metal impurity and a crystal defect in the semiconductor substrate can be gettered effectively. Also, since the number of BMDs of the semiconductor substrate per unit area of a cross section is equal to or less than 5×10⁷/cm², strength degradation of the semiconductor substrate caused by a dislocation and a slip can be prevented.

Furthermore, a size of a BMD included in the semiconductor substrate is in a range of 50 nm to 400 nm inclusive.

With the above-stated construction, since a size of a BMD is equal to or larger than 50 nm, a heavy-metal impurity and a crystal defect in a semiconductor substrate can be gettered effectively. Also, since the size of a BMD is equal to or less than 400 nm, strength degradation of the semiconductor substrate caused by a dislocation and a slip can be prevented.

Also, a thickness of the epitaxial layer is in a range of 4 µm to 6 µm inclusive.

With the above-stated construction, an influence of a concentration variation of an impurity in the semiconductor substrate on an electric characteristic of the epitaxial layer can be prevented, and an electric shutter voltage is made a low voltage.

Moreover, a ratio ρ2/ρ1 is in a range of 20 to 200 inclusive, ρ1 being a resistivity of the semiconductor substrate and ρ2 being a resistivity of the epitaxial layer.

With the above-stated construction, a solid-state image pickup device which makes the electric shutter voltage a low voltage, and satisfies various electric characteristics can be manufactured.

The above object is also fulfilled by a light-detecting device, comprising: a semiconductor substrate that is composed of a first element as a base material, and contains a second element at a predetermined concentration, the second element being a homologous element of the first element; and an epitaxial layer that is formed on the semiconductor substrate and composed of the first element as a base material, the epitaxial layer including a light-detecting unit a predetermined distance away from the semiconductor substrate, wherein the second element is substantially uniformly distributed in the entire semiconductor substrate.

The inventors confirm from an experiment that, with the above-stated construction, a gettering effect can be improved and an electric characteristic variation of a light-detecting device canbe reduced. The reasons why an electric characteristic variation can be reduced are as mentioned above. Note that the expression "substantially uniformly" in the description of the present invention indicates a state in which a ratio of an upper limit to a lower limit is within 10 when a concentration of a second element is measured in a plurality of areas in a semiconductor substrate.

The above object is also fulfilled by a manufacturing method of a light-detecting device, comprising the steps of: preparing a semiconductor substrate that is composed of a first element as a base material, and contains a second element at a predetermined concentration, the second element being a homologous element of the first element; growing an epitaxial layer that is composed of the first element as a base material on the semiconductor substrate; and forming a light-detecting unit in the epitaxial layer a predetermined distance away from the semiconductor substrate, wherein the semiconductor substrate is formed using a crystal growth method from melt obtained by melting a material containing the first element and a material containing the second element so that the second element is contained in the semiconductor substrate at the predetermined concentration.

The inventors confirm from an experiment that, with the above-stated construction, a gettering effect can be improved and an electric characteristic variation of a light-detecting device can be reduced. The reasons why an electric characteristic variation can be reduced are as mentioned above. Note that a semiconductor substrate can be prepared by manufacturing a semiconductor substrate in-house, or buying a manufactured semiconductor substrate from other companies.

Also, the first element is silicon, the second element is carbon, and the predetermined concentration is in a range of 1×10¹⁶ atoms/cm³ to 2.5×10¹⁷ atoms/cm³ inclusive.

With the above-stated construction, a BMD can be formed in a very dense state, and strength degradation of a semiconductor substrate can be prevented. The reasons are as mentioned above.

Moreover, the manufacturing method further comprises a step of: performing a heat treatment repeatedly on the semiconductor substrate after the growing step, wherein a first input temperature of the heat treatment is in a range of 600 degrees centigrade to 700 degrees centigrade inclusive.

With the above-stated construction, since a first heat treatment temperature is in a range of 600 degrees centigrade to 700 degrees centigrade inclusive, a nucleus of an oxygen precipitation defect is fully grown to remain without disappearing, and a BMD as a gettering site can be formed in a very dense state. As a result, a gettering effect canbe improved.

Furthermore, the manufacturing method further comprises a step of: performing a heat treatment on the semiconductor substrate before a gate insulator is formed on the epitaxial layer, wherein the heat treatment is performed under a condition that a highest temperature is in a range of 1000 degrees centigrade to 1100 degrees centigrade inclusive, and a processing time is in a range of 60 minutes to 600 minutes inclusive.

With the above-stated construction, a nucleus of an oxygen precipitation defect is fully grown, and a BMD as a gettering site can be formed in a very dense state. As a result, a gettering effect can be improved.

Also, a thickness of the epitaxial layer is in a range of 4 µm to 6 µm inclusive.

With the above-stated construction, an influence of a concentration variation of an impurity in the semiconductor substrate on an electric characteristic of the epitaxial layer can be prevented, and an electric shutter voltage is made a low voltage.

Moreover, a ratio ρ2/ρ1 is in a range of 20 to 200 inclusive, ρ1 being a resistivity of the semiconductor substrate and ρ2 being a resistivity of the epitaxial layer.

With the above-stated construction, a solid-state image pickup device which makes the electric shutter voltage a low voltage, and satisfies various electric characteristics can be manufactured.

### BRIEF DESCRIPTION OF THE DRAWINGS

These and the other objects, advantages and features of the inventionwill become apparent from the following description thereof taken in conjunction with the accompanying drawings which illustrate a specific embodiment of the invention. In the drawings:
Fig. 1 shows a schematic construction of an IT-CCD type solid-state image pickup device;
Fig. 2 is a cross section of an IT-CCD type solid-state image pickup device;
Fig. 3 shows electric potential distribution in a semiconductor substrate and an epitaxial layer;
Fig. 4 shows a manufacturing method of a solid-state image pickup device;
Fig. 5 shows a manufacturing method of a solid-state image pickup device;
Fig. 6 shows a manufacturing method of a solid-state image pickup device;
Fig. 7 is a comparative result of the number of white scratches;
Fig. 8 is a comparative result of a blooming suppression voltage;
Fig. 9 is a cross section of a wafer;
Fig. 10 shows electric potential distribution in a solid-state image pickup device;
Fig. 11 shows a schematic construction of a FT-CCD type solid-state image pickup device;
Fig. 12 is a cross section of a FT-CCD type solid-state image pickup device;
Fig. 13 is a cross section of a light-receiving element for photocoupler;
Fig. 14 is a comparative result of a resistivity variation in a same plane in an epitaxial layer; and
Fig. 15 is an observation result of a striation.

### DESCRIPTION OF THE PREFERRED EMBODIMENT

The following describes the best mode for carrying out the present invention, with reference to the attached drawings.

### [First embodiment]

### <Construction>

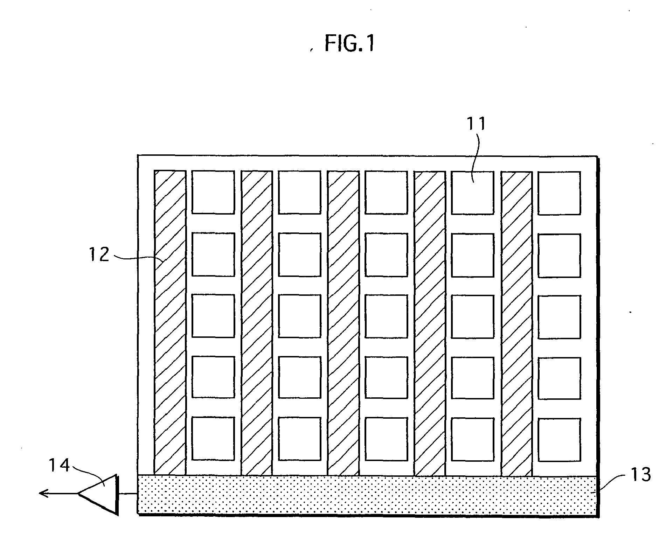

FIG. 1 shows a schematic construction of an IT-CCD type solid-state image pickup device.

The solid-state image pickup device includes a plurality of light-detecting units 11, a plurality of vertical transferring units 12, a horizontal transferring unit 13, and an amplifying unit 14.

The plurality of light-detecting units 11 are arranged in a matrix in a plane to generate charges corresponding to the amount of received light. The plurality of light-detecting units 11 for 25 pixels of 5 rows and 5 columns are shown in FIG. 1. Each of the plurality of vertical transferring units 12 transfers the charge generated by each of the plurality of light-detecting units 11 to the horizontal transferring unit 13. The horizontal transferring unit 13 transfers the charge from each of the plurality of vertical transferring units 12 to the amplifying unit 14. The amplifying unit 14 converts the charge from the horizontal transferring unit 13 into a voltage and outputs it.

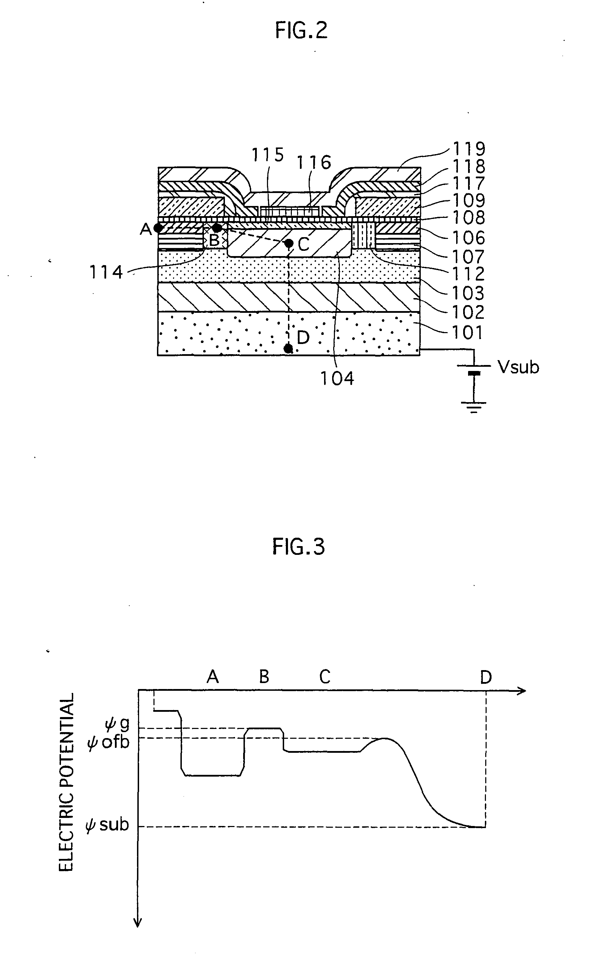

Fig. 2 is a cross section of the IT-CCD type solid-state image pickup device.

The solid-state image pickup device includes a semiconductor substrate 101, an epitaxial layer 102, a gate insulator 108, a gate electrode 109, an antireflection film 116, a light shielding film 118, an interlayer insulator 117, and a surface passivation film 119. Note that FIG. 2 shows the solid-state image pickup device corresponding to one pixel.

The semiconductor substrate 101 is composed of silicon as a base material and contains carbon and phosphorous. A carbon concentration is in a range of 1×10¹⁶ atoms/cm³ to 2.5×10¹⁷ atoms/cm³ inclusive. Note that carbon is substantially uniformly distributed in the semiconductor substrate 101 in a plane direction and a depth direction. Here, the expression "substantially uniformly" indicates a state in which a ratio of an upper limit to a lower limit is within 10 when a carbon concentration is measured in a plurality of areas in the semiconductor substrate 101.

The epitaxial layer 102 includes ap-type well region 103, n-type regions 104 and 106, and p-type regions 107, 112, 114, and 115. The p-type well region 103 forms the overflow barrier electric potential ψofb between the n-type region 104 and the semiconductor substrate 101. The n-type region 104 is formed in an area a predetermined distance away from the semiconductor substrate 101. A potential well is formed because the n-type region 104 is surrounded by the p-type well region 103 and the p-type regions 112 , 114, and 115. The area in which the potential well is formed corresponds to each of the plurality of light-detecting units 11. The n-type region 106 is surrounded by the p-type regions 107, 112, and 114. This forms a potential well. An area in which the potential well is formed is each of the plurality of vertical transferring units 12. The p-type region 114 forms gate electric potential ψg between the n-type region 104 and the n-type region 106.

The gate insulator 108, the gate electrode 109, the antireflection film 116, the light shielding film 118, the interlayer insulator 117, and the surface passivation film 119 are general components of a CCD type solid-state image pickup device and are not essential parts of the present invention. Therefore, explanations thereof are omitted.

Fig. 3 shows electric potential distribution in the semiconductor substrate and the epitaxial layer.

Symbols A to D shown in FIG. 3 correspond to points A to D shown in FIG. 2 respectively. In other words, the symbol A corresponds to each of the plurality of vertical transferring units 12; the symbol B.corresponds to the p-type region 114, the symbol C corresponds to each of the plurality of light-detecting units 11, and the symbol D corresponds to the semiconductor substrate 101.

The substrate voltage Vsub is applied to the semiconductor substrate 101. By the substrate voltage Vsub, the substrate electric potential ψsub and the overflow barrier electric potential ψofb are determined. In other words, as the substrate voltage Vsub becomes higher, the substrate electric potential ψsub and the overflow barrier electric potential ψofb become higher. The substrate voltage Vsub is determined so that the overflow barrier electric potential ψofb is higher than the gate electric potential ψg. With this construction, if each of the plurality of light-detecting units 11 generates a charge more than saturation volume, the overflowing charge can be discharged into not each of the plurality of vertical transferring units 12 but the semiconductor substrate 101. As a result, a blooming effect can be prevented. <Manufacturing method>

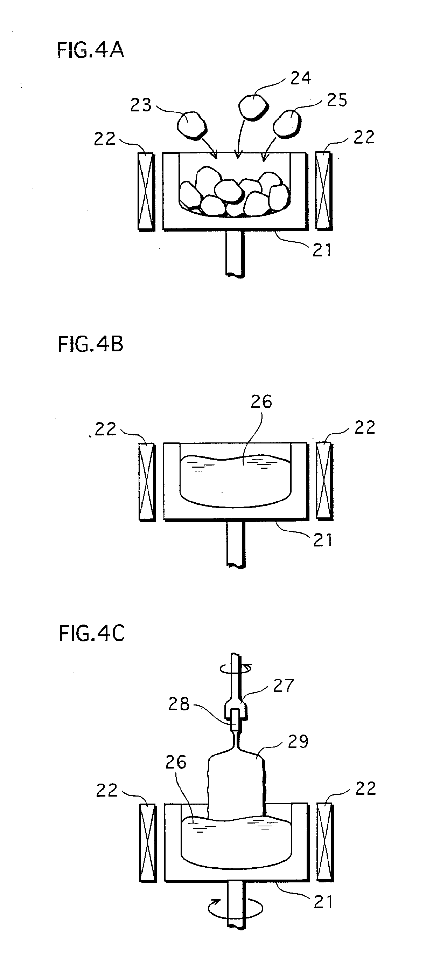

Figs. 4, 5, and 6 show a manufacturing method of the solid-state image pickup device.

Firstly, the semiconductor substrate 101 is formed using a pulling method.

A material containing silicon 23, a material containing carbon 24, and a material containing phosphorous 25 are put in a crucible 21 (FIG. 4A) . Here, a predetermined amount of the material containing carbon 24 is put in the crucible 21 so that the semiconductor substrate 101 contains carbon in a concentration range of 1×10¹⁶ atoms/cm³ to 2.5×10¹⁷ atoms/cm³ inclusive. As the material containing carbon 24, black lead, a SiC crystal and the like can be used. Note that a predetermined amount of the material containing phosphorous 25 is put in the crucible 21 so that the semiconductor substrate 101 has a resistivity in a range of 0.25 Ωcm to 0.5 Ωcm.

When the predetermined amount of each of the materials is put in the crucible 21, the materials of a single crystal ingot are melted using a heater 22 (FIG. 4B), a seed crystal 28 fixed to a supporting device 2 7 is contacted with melt obtained by melting the materials 26, and the seed crystal 28 is gradually pulled up (FIG. 4C). Then, a single crystal ingot 29 is grown. At this time, carbon is uniformly distributed in the single crystal ingot 29. The semiconductor substrate 101 is formed by cutting the single crystal ingot 29 so that the semiconductor substrate 101 has a plane direction <100>.

Next, a solid-state image pickup device is formed by processing the semiconductor substrate 101 as follows.

The semiconductor substrate 101 is prepared (FIG. 5A). Note that FIG. 5A shows a part of a cross section of the semiconductor substrate 101.

The epitaxial layer 102 is formed on the prepared semiconductor substrate 101 by growing a silicon crystal using an epitaxial growth method (FIG. 5B). A thickness of the epitaxial layer 102 is about 6µm, and a resistivity thereof is in a range of 10 Ωcm 15 Ωcm.

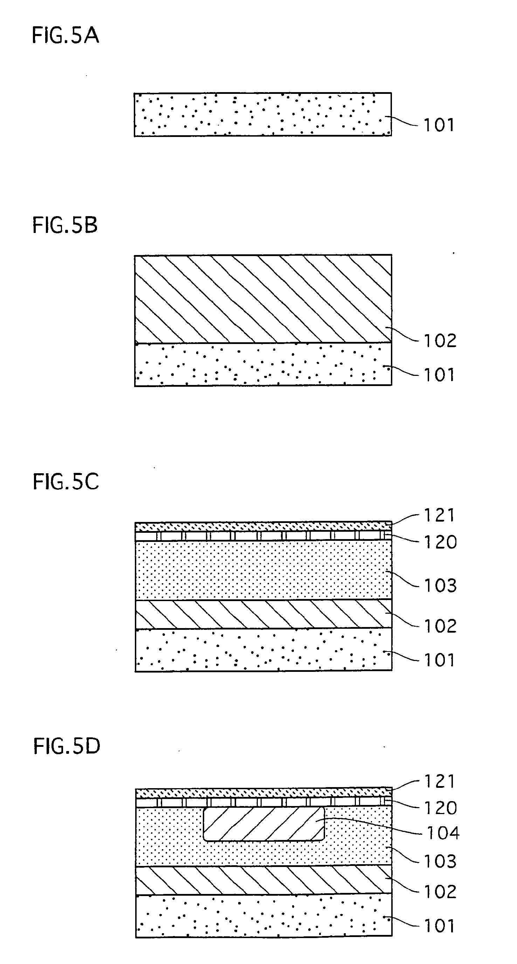

A silicon oxide film 120 is formed on the epitaxial layer 102, a silicon nitride film 121 is formed on the silicon oxide film 120, and a region other than a device forming region is removed. Then, the p-type well region 103 is formed by an ion implantation method (FIG. 5C). A forming condition of the silicon oxide film 120 is as follows. An input temperature is 700 degrees centigrade, a highest temperature is 1000 degrees centigrade, and a retention time at 1000 degrees centigrade is 60 minutes. In the region other than the device forming region of the epitaxial layer 102, by thermal oxidation, a silicon film is formed using a technology called "LOCOS" . A forming condition of the silicon film is that a highest temperature is 1000 degrees centigrade, and a retention time at 1000 degrees centigrade is 100 minutes.

After the silicon film is formed, the n-type region 104 is formed in the epitaxial layer 102 by an ion implantation method (FIG. 5D). After the ion implantation, a heat treatment is performed under a condition in which a highest temperature is 1000 degrees centigrade, and a retention time at 1000 degrees centigrade is 20 minutes.

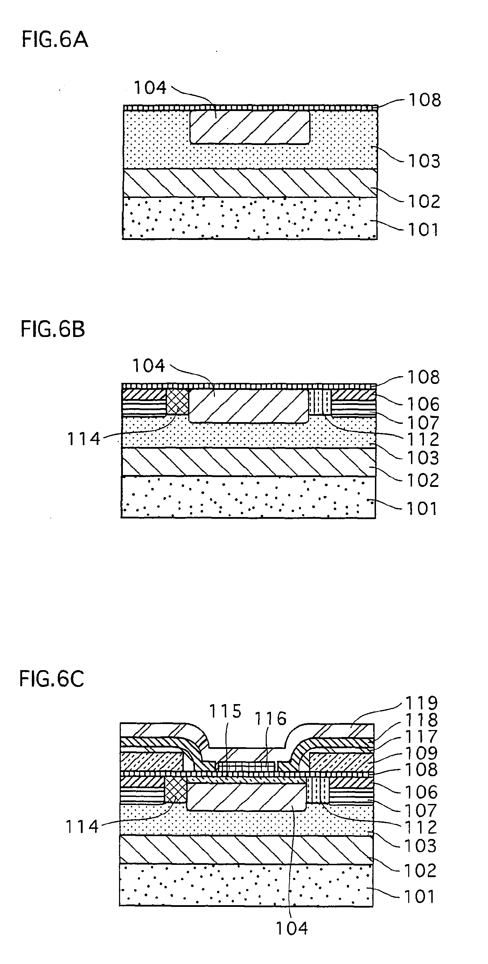

Next, the silicon oxide film 120 and the silicon nitride film 121 are removed, and the gate insulator 108 is formed on the epitaxial layer 102 (FIG. 6A).

Then, the p-type regions 107, 112, 114, and the n-type region 106 are formed by an ion implantation method (FIG. 6B). After the gate electrode 109 is formed on the gate insulator 108, the p-type region 115 is formed. Also, the antireflection film 116, the interlayer insulator 117, the light shielding film 118, and the surface passivation film 119 are formed (FIG. 6C). If necessary, a color filter and a microlens are formed.

In the above-mentioned manufacturing method, from when the epitaxial layer 102 is formed to when the gate insulator 108 is formed, the heat treatment process is performed in which the input temperature of the first heat treatment is 700 degrees centigrade, the highest temperature is 1000 degrees, and a total retention time is 180 minutes. As a result, a density of a BMD (Bulk Micro Defect) per unit area of a cross section is about 1x10⁶/cm², and a size of the BMD is about 200 nm.

Note that if a heat treatment is performed in which an input temperature is 700 degrees centigrade, a highest temperature is 1100 degrees centigrade, and a total retention time is 300 minutes, a density of a BMD per unit area of a cross section is about 5×10⁶/cm², and a size of the BMD is about 300 nm.

Also, if a heat treatment is performed in which an input temperature is 600 degrees centigrade, a highest temperature is 1000 degrees centigrade, and a total retention time is 180 minutes, a density of a BMD per unit area of a cross section is about 5×10⁶/cm², and a size of the BMD is about 50 nm.

### <Performance evaluation>

The inventors manufactured three types of solid-state image pickup devices using three different manufacturing methods of a conventional technology 1, a conventional technology 2, and the present invention in order to evaluate their performance.

With regard to a solid-state image pickup device of the conventional technology 1, only IG as a typical gettering technology is applied. In other words, a BMD is generated inside of a semiconductor substrate by a heat treatment (carbon is not added).

With regard to a solid-state image pickup device of the conventional technology 2, a gettering technology of Japanese Published Patent Application No. H06-338507 (Japanese Patent No. 3384506) is applied. In other words, a BMD is generated by an ion implantation technology for implanting carbon into a silicon substrate.

With regard to a solid-state image pickup device of the present invention, a BMD is generated by melting carbon into a silicon substrate when a crystal grows.

The performance was evaluated by measuring the number of white scratches and a blooming suppression voltage (a type of an electrical characteristic) of each of the solid-state image pickup devices, and comparing each of measurement results. The number of pixels of each of the solid-state image pickup devices is five million pixels and the number of samples of each of the solid-state image pickup devices is 100.

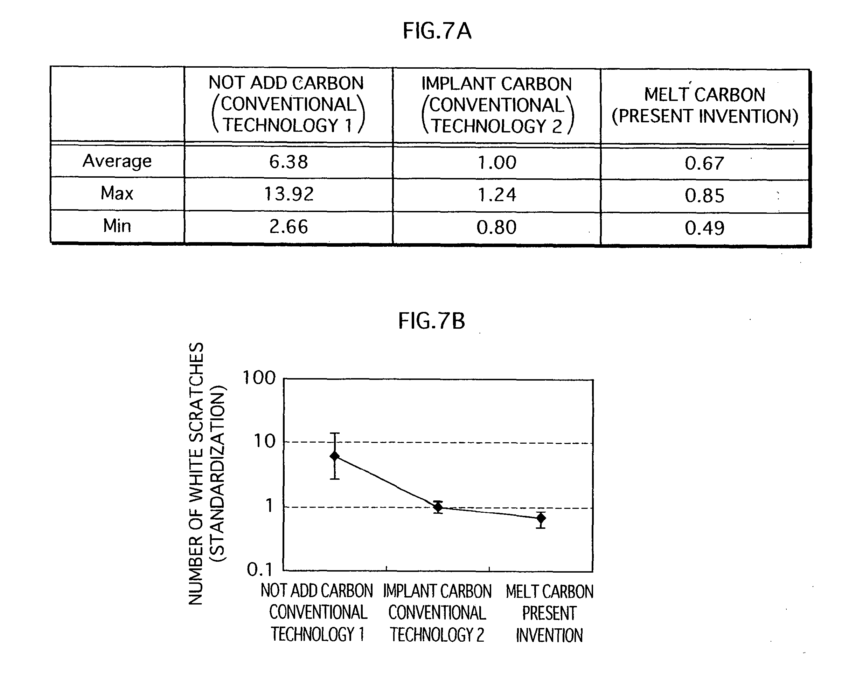

Fig. 7 is a comparative result of the number of white scratches.

When the number of white scratches was measured, the following pixel was regarded as a white scratch. The pixel had a signal that was equal to or larger than a threshold value when charge accumulation was performed on each of the solid-state image pickup devices in a state of light shielding for 4 seconds under a condition in which an environmental temperature was 60 degrees centigrade.

In FIG. 7, an average of the number of white scratches obtained from the solid-state image pickup device of the conventional technology 2 is standardized as a reference value. With regard to the average of the number of white scratches, the conventional technology 1 is 6.38, the conventional technology 2 is 1, and the present invention is 0.67. This result shows that the solid-state image pickup devices of the conventional technology 2 and the present invention to which carbon is added can significantly reduce the number of white scratches compared to the solid-state image pickup device of the conventional technology 1 to which carbon is not added. Also, the solid-state image pickup device of the present invention can reduce the number of white scratches by about 30 percent compared to the solid-state image pickup device of the conventional technology 2.

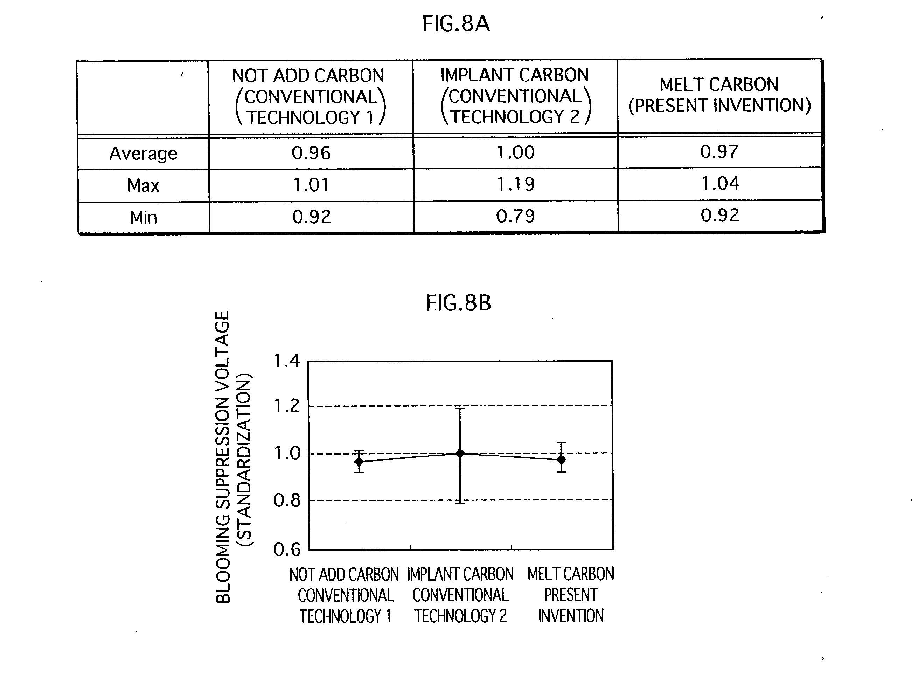

Fig. 8 is a comparative result of a blooming suppression voltage.

When the blooming suppression voltage was measured, the following value of a substrate voltage was regarded as the blooming suppression voltage. The value was a lower limit of a substrate voltage at which a blooming effect did not occur when the substrate voltage was varied by irradiating intense light under a condition in which an environmental temperature was 35 degrees centigrade.

In FIG. 8, an average of the blooming suppression voltage obtained from the solid-state image pickup device of the conventional technology 2 is standardized as a reference value. With regard to a variation of the blooming suppression voltage (a difference between a maximum value and a minimum value), the conventional technology 1 is 0.09, the conventional technology 2 is 0.4, and the present invention is 0.12. This result shows that the solid-state image pickup device of the present invention can reduce the variation of the blooming suppression voltage by half compared to the solid-state image pickup device of the conventional technology 2.

The above-mentioned experimental result is summarized as follows. With the construction of the present invention, a gettering effect can be improved, and a variation of a blooming suppression voltage can be reduced.

The inventors suppose that a variation of a blooming suppression voltage can be reduced by the following reasons.
(1) A variation of a blooming suppression voltage is caused by a distribution variation of carbon in a semiconductor substrate.
(2) By adding carbon to melt obtained by melting materials of a semiconductor substrate, a distribution variation of carbon in a semiconductor substrate can be more reduced compared to an ion implantation method for implanting carbon.

The reason (1) is presumed as follows.

A BMD tends to be generated near carbon. Therefore, distribution of a BMD varies depending on distribution of carbon. A distribution variation of a BMD causes variations of parasitic capacity, parasitic resistance, and the like in the semiconductor substrate 101. As a result, a blooming suppression voltage varies.

The reason (2) is presumed as follows.

By adding carbon to melt obtained by melting materials of a semiconductor substrate, carbon is substantially uniformly distributed in the semiconductor substrate in a crystal growth process. On the other hand, if carbon is added by an ion implantationmethod, it is difficult that carbon is substantially uniformly distributed in a semiconductor substrate. This is mainly because an ion beam has a gradient of an ion density in a radial direction, and there may be an accuracy error when an ion beam is scanned in a whole area of a semiconductor substrate (wafer). Considering this, a distribution variation of carbon in a semiconductor substrate can be more reduced by adding carbon to melt obtained by melting materials of a semiconductor substrate compared to an ion implantation method for implanting carbon.

The above-mentionedmodel will be described with reference to the attached drawings.

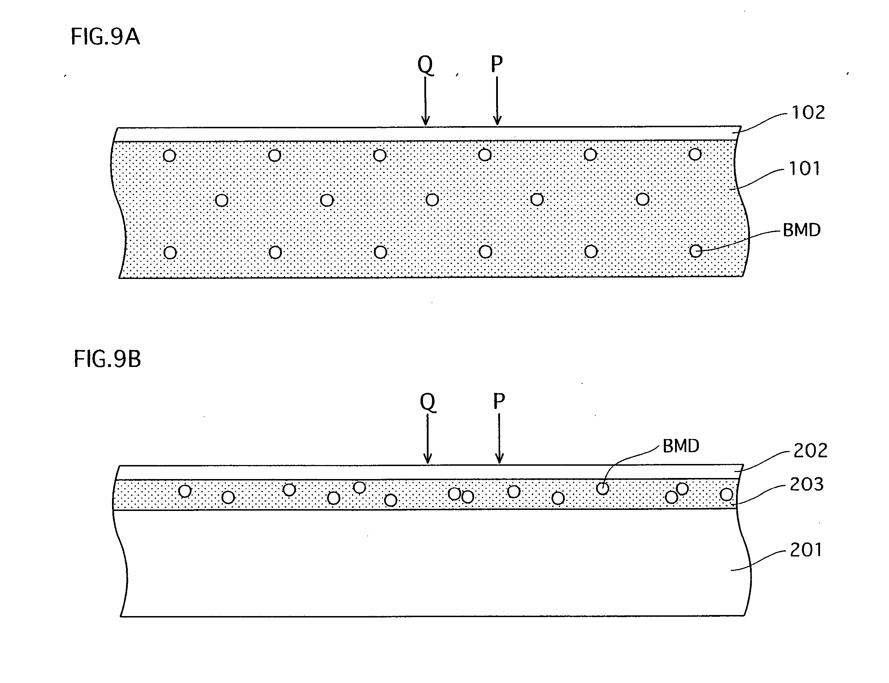

Fig. 9 is a cross section of a wafer.

FIG. 9A is a wafer of the present invention, and FIG. 9B is a wafer of the conventional technology 2. A distribution variation of a BMD in the semiconductor substrate 101 of the present invention is smaller than that in a semiconductor substrate 201 of the conventional technology 2. This is because a distribution variation of carbon in the semiconductor substrate 101 of the present invention is smaller than that in the semiconductor substrate 201 of the conventional technology 2. Note that a BMD substantially uniformly occurs in a whole area of the semiconductor substrate 101 of the present invention. On the other hand, in the semiconductor substrate 201 of the conventional technology 2, a BMD occurs mainly in a region 203 in which carbon is implanted by an ion implantation method.

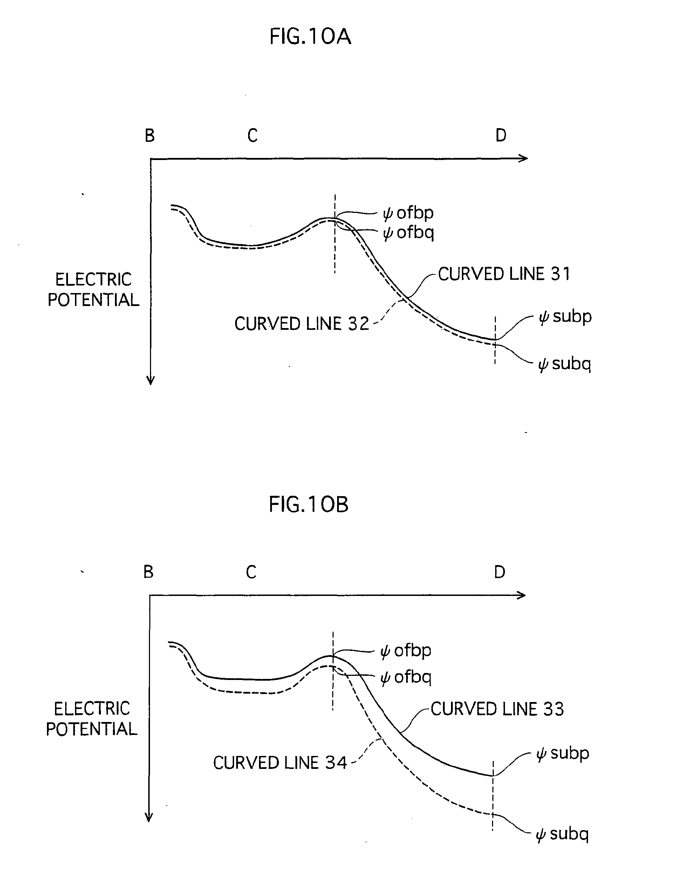

Fig. 10 shows electric potential distribution in a solid-state image pickup device.

FIG. 10A is electric potential distribution of a solid-state image pickup device manufactured by a manufacturing method of the present invention, and FIG. 10B is electric potential distribution of a solid-state image pickup device manufactured by a manufacturing method of the conventional technology 2. Symbols B to D shown in FIG. 10 correspond to the points B to D shown in FIG. 2 respectively. In other words, the symbol B corresponds to the p-type region 114, the symbol C corresponds to each of the plurality of light-detecting units 11, and the symbol D corresponds to the semiconductor substrate 101.

In FIG. 10A, a curved line 31 indicates electric potential distribution when the solid-state image pickup device is formed in a region P shown in FIG. 9A, and a curved line 32 indicates electric potential distribution when the solid-state image pickup device is formed in a region Q shown in FIG. 9A.

In FIG. 10B, a curved line 33 indicates electric potential distribution when the solid-state image pickup device is formed in a region P shown in FIG. 9B, and a curved line 34 indicates electric potential distribution when the solid-state image pickup device is formed in a region Q shown in FIG. 9B.

A distribution variation of a BMD in the solid-state image pickup device of the present invention is smaller than that in the solid-state image pickup device of the conventional technology 2. As a result, a variation of parasitic capacity and the like in the semiconductor substrate is small, and a variation of electric potential distribution is also small. Because a variation of the overflow barrier electric potential (a difference between ψofbp and ψofbq) in the solid-state image pickup device of the present invention is smaller than that in the solid-state image pickup device of the conventional technology 2, a variation of a blooming suppression voltage is also small.

Considering that a variation of electric potential distribution in the solid-state image pickup device of the present invention is smaller than that in the solid-state image pickup device of the conventional technology 2, electric characteristics variations other than a blooming suppression voltage such as saturation volume of a light-detecting unit, a read voltage and the like can be reduced. Therefore, the solid-state image pickup device of the present invention has an effect of reducing image degradation caused by an electric characteristic variation under low-intensity light.

If a semiconductor substrate is formed using a pulling method, in principle, a concentric variation occurs in a concentration of an impurity (such as phosphorus) in a same plane. If an epitaxial layer is formed on the semiconductor substrate, the impurity in the semiconductor substrate thermal-diffuses in the epitaxial layer. As a result, the concentric variation occurs in the concentration of the impurity even in a same plane in the epitaxial layer. This concentration variation of the impurity causes a resistivity variation in the same plane in the epitaxial layer, and in a solid-state image pickup device, the variation is observed as striped image noise that is called a striation.

The inventors manufactured three types of semiconductor substrates to which three different gettering technologies of the conventional technology 1, the conventional technology 2, and the present invention are applied in order to measure the resistivity variation in the same plane in the epitaxial layer.

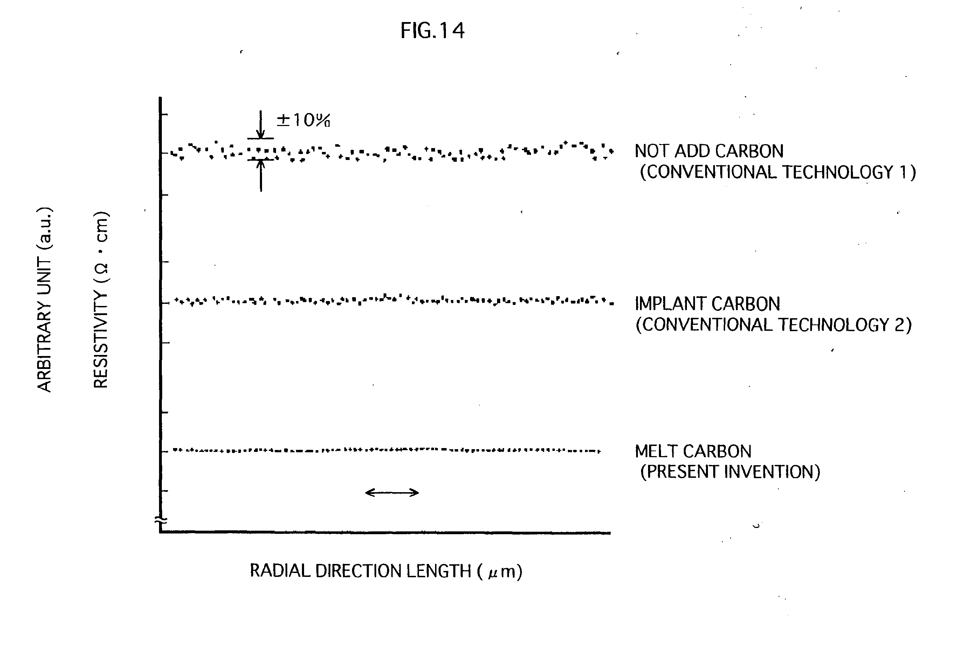

Fig. 14 is a comparative result of the resistivity variation in the same plane in the epitaxial layer.

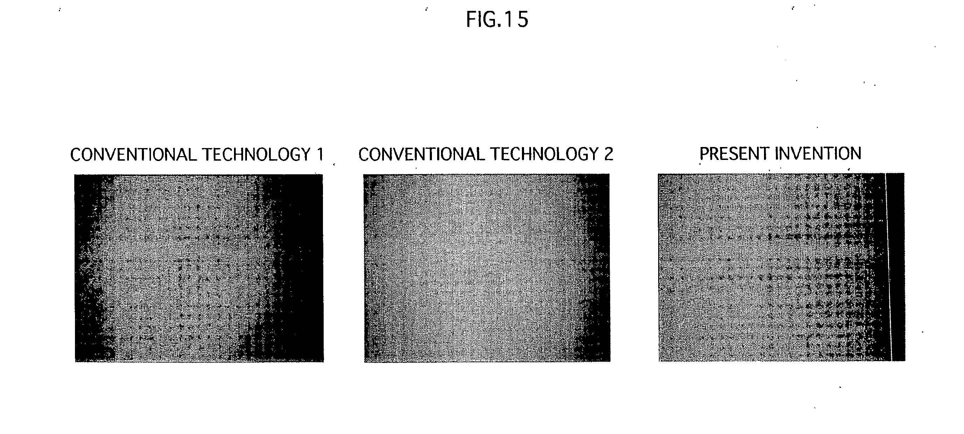

This' result shows that the resistivity variation in the same plane in the present invention is smallest, followed by the conventional technology 2 and the conventional technology 1, in that order. Therefore, the gettering technology of the present invention can suppress the occurrence of the striation. The inventors actually manufactured three types of solid-state image pickup devices by applying the three different gettering technologies of the conventional technology 1, the conventional technology 2, and the present invention, and observed images outputted from the solid-state image pickup devices (referred to FIG. 15). As a result, the occurrence of the striation was confirmed in the conventional technology 1 and the conventional technology 2. However, the occurrence of the striation was not confirmed in the present invention (the striation appears as a striped shade in an oblique direction to the images in FIG. 15).

It is supposed that the gettering technology of the present invention can suppress the occurrence of the striation by the following reasons.

The striation occurs because the impurity thermal-diffuses from the semiconductor substrate to the epitaxial layer. The thermal diffusion of the impurity is promoted by a silicon atom which moves from a grid point to a grid interval (what is called interstitial silicon), and an atomic vacancy which is formed on the grid point by the movement of the silicon atom. In the gettering technology of the present invention, carbon is melted into the semiconductor substrate that is composed of silicon as a base material. Therefore, the interstitial silicon and the atomic vacancy are trapped by carbon. As a result, the thermal diffusion of the impurity and the occurrence of the striation can be suppressed.

Moreover, in the gettering technology of the present invention, carbon, which traps the interstitial sili.con and the atomic vacancy, is distributed in the entire semiconductor substrate. Therefore, the gettering technology of the present invention has higher ability of suppressing the thermal diffusion of the impurity and the occurrence of the striation, compared to the gettering technology of the conventional technology 2 in which carbon is distributed only in a part of the semiconductor substrate.

Note that as an effective method of reducing electric power consumption of a solid-state image pickup device, a voltage, which is applied to a semiconductor substrate when an electric shutter is operated (electric shutter voltage), is made a low voltage. In order to make the electric shutter voltage a low voltage, it is effective to thin an epitaxial layer. However, the thinner the epitaxial layer is, the greater an influence of a concentration variation of an impurity in the semiconductor substrate on an electric characteristic of the epitaxial layer is. As a result, the striation is likely to occur. Since the gettering technology of the present invention can suppress the occurrence of the striation, the epitaxial layer can be thinned more. Therefore, the electric power consumption of the solid-state image pickup device can be reduced.

Specifically, it is preferable that a thickness of an epitaxial layer is in a range of 4 µm to 6 µm inclusive. An absorption length of red light in silicon is about 3 µm. Therefore, each of the plurality of light-detecting units 11 is designed so that a depletion layer reaches to a depth of at least about 3 µm from a surface of the epitaxial layer in order to detect the red light effectively. When a voltage is applied to a gate electrode, the depletion layer extends about 1 µm in a depth direction. Therefore, it is preferable that the thickness of the epitaxial layer is equal to or larger than 4 µm to prevent the depletion layer from reaching to the semiconductor substrate. If the thickness of the epitaxial layer is larger than 6 µm, the electric shutter voltage is required to be high, and it is difficult to reduce the electric power consumption. Thus, it is preferable that the thickness of the epitaxial layer is equal to or smaller than 6 µm.

Also, it is preferable that a ratio ρ2/ρ1 which is a ratio of a semiconductor substrate resistivity ρ1 to an epitaxial layer resistivity ρ2 is in a range of 20 to 200 inclusive. In order to manufacture a solid-state image pickup device which satisfies various electric characteristics, the epitaxial layer resistivity ρ2 is required to be about 10 Ωm to 50 Ωcm. On the other hand, in order to make the electric shutter voltage a low voltage, the semiconductor substrate resistivity ρ1 is required to be about 0.25 Ωm to 0.5 Ωcm. If the ratio ρ2/ρ1 is in a range of 20 to 200 inclusive, the solid-state image pickup device which makes the electric shutter voltage a low voltage, and satisfies the various electric characteristics can be manufactured.

### [Second embodiment]

### <Construction>

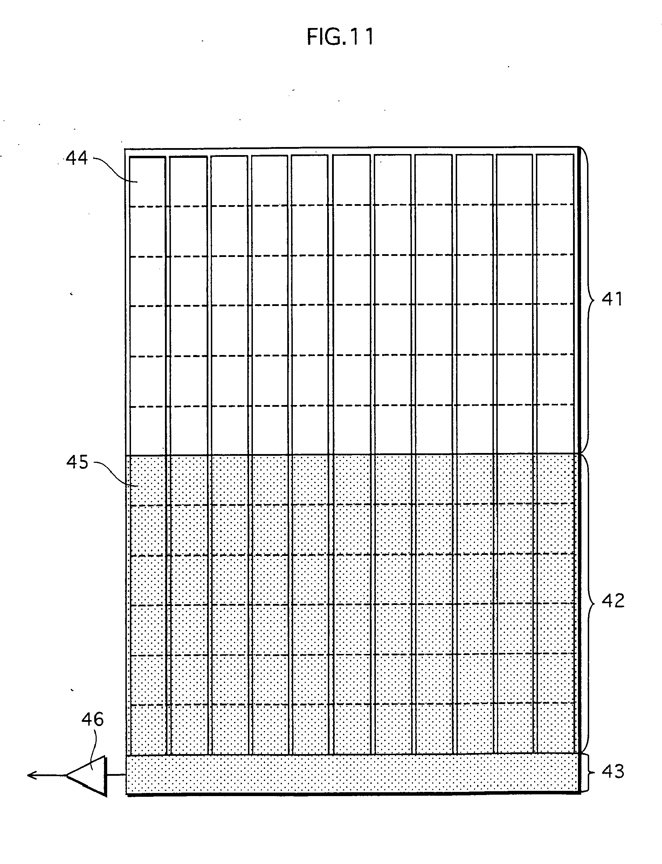

Fig. 11 shows a schematic construction of a FT-CCD type solid-state image pickup device.

The solid-state image pickup device includes a light-receiving region 41, an accumulation region 42, a horizontal transferring unit 43, and an amplifying unit 46.

The light-receiving region 41 has a plurality of light-detecting units 44. Each of the plurality of light-detecting units 44 generates a charge corresponding to the amount of received light, and functions as a vertical transferring unit. The accumulation region 42 has a plurality of accumulation units 45. Each of the plurality of accumulation units 45 accumulates the charge transferred from each of the plurality of light-detecting units 44, and functions as a vertical transferring unit. The plurality of light-detecting units 44 and the plurality of accumulation units 45 are arranged in a matrix in a plane. Each of the plurality of light-detecting units 44 and the plurality of accumulation units 45 for 66 pixels of 6 rows and 11 columns are shown in FIG. 11. The horizontal transferring unit 43 transfers the charge transferred from each of the plurality of accumulation units 45 to the amplifying unit 46. The amplifying unit 46 converts the charge from the horizontal transferring unit 43 into a voltage and outputs it.

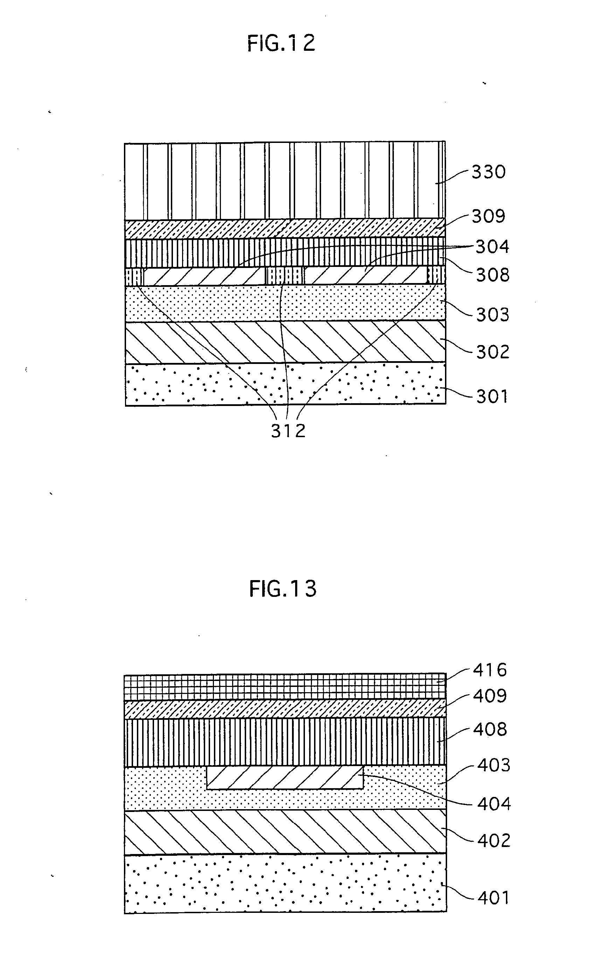

Fig. 12 is a cross section of the FT-CCD type solid-state image pickup device.

The solid-state image pickup device includes a semiconductor substrate 301, an epitaxial layer 302, a gate insulator 308, a transparent electrode 309, and a planarizing layer 330. Note that FIG. 12 shows the solid-state image pickup device corresponding to two pixels.

The semiconductor substrate 301 is composed of silicon as a base material and contains carbon and phosphorous. Carbon is substantially uniformly distributed in the semiconductor substrate 301 in a plane direction and a depth direction. A carbon concentration is 5×10¹⁶ atoms/cm³.

The epitaxial layer 302 includes a p-type well region 303, a plurality of n-type regions 304, and a plurality of p-type regions 312. The p-type well region 303 forms the overflow barrier electric potential ψofb between the plurality of n-type regions 304 and the semiconductor substrate 301. The plurality of n-type regions 304 are formed in areas a predetermined distance away from the semiconductor substrate 301. Potential wells are formed because the plurality of n-type regions 304 are surrounded by the p-type well region 303 and the plurality of p-type regions 312. Each of areas in which the potential wells are formed corresponds to each of the plurality of light-detecting units 44.

The gate insulator 308, the transparent electrode 309, and the planarizing layer 330 are general components of a CCD type solid-state image pickup device and are not essential parts of the present invention. Therefore, explanations thereof are omitted.

### <Manufacturing method>

A main difference between the manufacturing method of the first embodiment and a manufacturing method of a second embodiment is a temperature of a heat treatment. Therefore, only matters concerning the heat treatment will be described.

A silicon oxide film and a silicon nitride film are formed on the epitaxial layer 302, and a region other than a device forming region is removed. Then, the p-type well region 303 is formed by an ion implantation method. A forming condition of the silicon oxide film is as follows. An input temperature is 600 degrees centigrade, a highest temperature is 1000 degrees centigrade, and a retention time at 1000 degrees centigrade is 60 minutes. In the region other than the device forming region of the epitaxial layer 302, by thermal oxidation, a silicon film is formed using a technology called "LOCOS" . A forming condition of the silicon film is that a highest temperature is 1050 degrees centigrade, and a retention time at 1050 degrees centigrade is 100 minutes.

In the above-mentioned manufacturing method, from when the epitaxial layer 302 is formed to when the gate insulator 308 is formed, the heat treatment is performed in which the input temperature of the first heat treatment process is 600 degrees centigrade, the highest temperature is 1050 degrees, and a total retention time is 160 minutes. As a result, a density of a BMD per unit area of a cross section is about 5×10⁶/cm², and a size of the BMD is about 100 nm.

### [Third embodiment]

### <Construction>

Fig. 13 is a cross section of a light-receiving element for photocoupler.

The light-receiving element includes a semiconductor substrate 401, an epitaxial layer 402, an insulating film 408, a transparent electrode 409, and an antireflection film 416.

The semiconductor substrate 401 is composed of silicon as a base material and contains carbon and phosphorous. Carbon is substantially uniformly distributed in the semiconductor substrate 401 in a plane direction and a depth direction. A carbon concentration is in a range of 1×10¹⁶ atoms/cm³ to 2.5×10¹⁷ atoms/cm³ inclusive.

The epitaxial layer 402 includes a p-type well region 403 and a n-type region 404. The p-type well region 403 forms the overflow barrier electric potential ψofb between the n-type region 404 and the semiconductor substrate 401. A potential well is formed because the n-type region 404 is surrounded by the p-type well region 403. An area in which the potential well is formed corresponds to a light-detecting unit.

The insulating film 408, the transparent electrode 409, and the antireflection film 416 are general components of a light-receiving element and are not essential parts of the present invention. Therefore, explanations thereof are omitted.

Up to now, the light-detecting device of the present invention has been described specifically through the embodiments. However, the technical scope of the present invention is not limited to the above-described embodiments. For example, the following are modifications.
(1) In the embodiments, a single crystal ingot is grown by puling using a CZ method. However, the present invention is not limited to the CZ method, and a MCZ method may be used for applying a magnetic field when a single crystal is grown.
(2) In the embodiments, an IT-CCD type solid-state image pickup device and a FT-CCD type solid-state image pickup device are taken as examples. However, the present invention is not limited to these types, and may be applied to a MOS type solid-state image pickup device. Also, in the embodiments, a light-receiving element for photocoupler is taken as an example. However, the present invention is not limited to this, and may be applied to light-receiving elements for optical communication and an optical pickup.
(3) In the embodiments, an example of adding carbon is given. However, the present invention is not limited to this, and homologous elements of silicon such as germanium, tin, lead, and the like may be added.
   Also, in the embodiments, a silicon substrate is taken as an example. However, the present invention is not limited to this, and may be applied to a germanium substrate.
(4) In the embodiments, phosphorous is added for a conductivity type of a semiconductor substrate to be a n-type. However, the present invention is not limited to this.

Although the present invention has been fully described by way of examples with reference to the accompanying drawings, it is to be noted that various changes and modifications will be apparent to those skilled in the art. Therefore, unless otherwise such changes and modifications depart from the scope of the present invention, they should be construed as being included therein.

## Claims

1. A light-detecting device, comprising:
a semiconductor substrate that is composed of a first element as a base material, and contains a second element at a predetermined concentration, the second element being a homologous element of the first element; and
an epitaxial layer that is formed on the semiconductor substrate and composed of the first element as a base material, the epitaxial layer including a light-detecting unit a predetermined distance away from the semiconductor substrate, wherein
the semiconductor substrate is formed using a crystal growth method from melt obtained by melting a material containing the first element and a material containing the second element so that the second element is contained in the semiconductor substrate at the predetermined concentration.

2. The light-detecting device of Claim 1, wherein
the first element is silicon, the second element is carbon, and
the predetermined concentration is in a range of 1×10¹⁶ atoms/cm³ to 2.5×10¹⁷ atoms/cm³ inclusive.

3. The light-detecting device of Claim 1, wherein
a number of BMDs included in the semiconductor substrate per unit area of a cross section is in a range of 5×10⁵/cm² to 5×10⁷/cm² inclusive.

4. The light-detecting device of Claim 1, wherein
a size of a BMD included in the semiconductor substrate is in a range of 50 nm to 400 nm inclusive.

5. The light-detecting device of Claim 1, wherein
a thickness of the epitaxial layer is in a range of 4 µm to 6 µm inclusive.

6. The light-detecting device of Claim 1, wherein
a ratio ρ2/ρ1 is in a range of 20 to 200 inclusive, ρ1 being a resistivity of the semiconductor substrate and ρ2 being a resistivity of the epitaxial layer.

7. A light-detecting device, comprising:
a semiconductor substrate that is composed of a first element as a base material, and contains a second element at a predetermined concentration, the second element being a homologous element of the first element; and
an epitaxial layer that is formed on the semiconductor substrate and composed of the first element as a base material, the epitaxial layer including a light-detecting unit a predetermined distance away from the semiconductor substrate, wherein
the second element is substantially uniformly distributed in the entire semiconductor substrate.

8. The light-detecting device of Claim 7, wherein
the first element is silicon, the second element is carbon, and
the predetermined concentration is in a range of 1×10¹⁶ atoms/cm³ to 2.5×10¹⁷ atoms/cm³ inclusive.

9. The light-detecting device of Claim 7, wherein
a number of BMDs included in the semiconductor substrate per unit area of a cross section is in a range of 5×10⁵/cm² to 5×10⁷/cm² inclusive.

10. The light-detecting device of Claim 7, wherein
a size of a BMD included in the semiconductor substrate is in a range of 50 nm to 400 nm inclusive.

11. The light-detecting device of Claim 7, wherein
a thickness of the epitaxial layer is in a range of 4 µm to 6 µm inclusive.

12. The light-detecting device of Claim 7, wherein
a ratio ρ2/ρ1 is in a range of 20 to 200 inclusive, ρ1 being a resistivity of the semiconductor substrate and ρ2 being a resistivity of the epitaxial layer.

13. A manufacturing method of a light-detecting device, comprising the steps of:
preparing a semiconductor substrate that is composed of a first element as a base material, and contains a second element at a predetermined concentration, the second element being a homologous element of the first element;
growing an epitaxial layer that is composed of the first element as a base material on the semiconductor substrate; and
forming a light-detecting unit in the epitaxial layer a predetermined distance away from the semiconductor substrate, wherein
the semiconductor substrate is formed using a crystal growth method from melt obtained by melting a material containing the first element and a material containing the second element so that the second element is contained in the semiconductor substrate at the predetermined concentration.

14. The manufacturing methodof Claim 13, wherein
the first element is silicon, the second element is carbon, and
the predetermined concentration is in a range of 1×10¹⁶ atoms/cm³ to 2.5×10¹⁷ atoms/cm³ inclusive.

15. The manufacturing method of Claim 13, further comprising a step of:
performing a heat treatment repeatedly on the semiconductor substrate after the growing step, wherein
a first input temperature of the heat treatment is in a range of 600 degrees centigrade to 700 degrees centigrade inclusive.

16. The manufacturing methodof Claim 13, further comprising a step of:
performing a heat treatment on the semiconductor substrate before a gate insulator is formed on the epitaxial layer, wherein
the heat treatment is performed under a condition that a highest temperature is in a range of 1000 degrees centigrade to 1100 degrees centigrade inclusive, and a processing time is in a range of 60 minutes to 600 minutes inclusive.

17. The light-detecting device of Claim 13, wherein
a thickness of the epitaxial layer is in a range of 4 µm to 6 µm inclusive.

18. The light-detecting device of Claim 13, wherein
a ratio ρ2/ρ1 is in a range of 20 to 200 inclusive, ρ1 being a resistivity of the semiconductor substrate and ρ2 being a resistivity of the epitaxial layer.
